# EUROPÄISCHE PATENTSCHRIFT

(11) **EP 1 028 525 B1**
(45) Veröffentlichungstag und Bekanntmachung des Hinweises auf die Patenterteilung: **17.03.2004**
(21) Anmeldenummer: 99125605.8
(22) Anmeldetag: 22.12.1999
(51) Int. Cl.: H03G 3/30

(54) **Tragbarer Funksender, insbesondere Funkschlüssel**
Portable transmitter, in particular a radio key
Emetteur portable, notamment clef à télécommande radiofréquence

(30) Priorität: 11.02.1999 DE 19905635
(43) Veröffentlichungstag der Anmeldung: 16.08.2000
(73) Patentinhaber: DaimlerChrysler AG, 70567 Stuttgart (DE)
(72) Erfinder: Reinhardt, Matthias, 71364 Winnenden (DE)

(56) Entgegenhaltungen:
- EP-A- 0 654 900
- EP-A- 0 775 792

## Beschreibung

Die Erfindung bezieht sich auf einen tragbaren Funsender nach dem Oberbegriff des Anspruchs 1, der sich insbesondere als Funkschlüssel für ein Kraftfahrzeug eignet. Für moderne Automobile werden als zugangs- und/oder nutzungsberechtigende Elemente vermehrt sogenannte elektronische Schlüssel anstelle der früheren mechanischen Schlüssel eingesetzt. Im Spezialfall von Funkschlüsseln werden die zugangs- bzw. nutzungsberechtigenden Code-Informationen über eine Funkstrecke zum Fahrzeug übertragen. Herkömmliche Funkschlüssel weisen hierzu einen Oszillator als Spannungssignalgeneratorteil auf, der gleichzeitig die Antenne beinhaltet. Dies kann jedoch zu relativ großen Streuungen der Sendeleistung des Funkschlüssels von typischerweise bis zu 6dB, bei zusätzlicher Temperaturdrift bis ca. 9dB führen, so daß allein dadurch eine Reichweitenreduzierung bis auf etwa 1/3 des ursprünglichen, gewünschten Wertes auftreten kann.

Aus der Offenlegungsschrift DE 43 39 526 A1 ist ein Funksender der eingangs genannten Art in Form eines Mobilfunkgerätes, d.h. eines Handfunkgerätes oder Handys, bekannt. Beim dortigen Handfunkgerät wird das von einem nicht weiter spezifizierten Spannungssignalgeneratorteil erzeugte Wechselspannungssignal, das aus einem hochfrequenten Trägersignal mit zeitkomprimiert aufmoduliertem Sprechsignal besteht, einem leistungsregelbaren HF-Treiberverstärker zugeführt. Dessen Ausgangssignal ist einer HF-Leistungsendstufe mit konstanter Leistungsverstärkung zugeführt, deren Ausgangssignal über ein HF-Ausgangsfilter zu einer Antenne geführt ist. Zum anderen ist das Ausgangssignal des HF-Treiberverstärkers über einen Trennverstärker einer HF-Gleichrichterstufe zugeführt. Der Trennverstärker gibt ein zur HF-Leistung proportionales Ausgangssignal ab. In der Gleichrichterstufe wird dieses Signal über einen Koppelkondensator zur Kathodenseite einer HF-Gleichrichterdiode geführt, die anodenseitig über einen weiteren Kondensator an Masse liegt und zudem über eine HF-Drossel mit einer als Gleichstromvorspannung fungierenden Vergleichsspannung beaufschlagt ist. Zur Kompensation der Gleichstromvorspannung ist in der Gleichrichterstufe ein paralleler, identisch aufgebauter Diodenzweig vorgesehen, dessen kathodenseitige Ausgangsspannung mit derjenigen der Gleichrichterdiode in einem Summierverstärker subtrahiert wird, so daß der Summierverstärker ausgangsseitig nur noch die gleichgerichtete HF-Spannung abgibt. Dieses Summierverstärker-Ausgangssignal beaufschlagt den invertierenden Eingang eines Operationsverstärkers, dessen nicht-invertierender Eingang mit einer die gewünschte Ausgangsleistung repräsentierenden Leistungsvorgabespannung beaufschlagt ist und dessen Ausgangssignal als Steuerspannung zur Leistungseinstellung des HF-Treiberverstärkers dient.

Der Erfindung liegt als technisches Problem die Bereitstellung eines tragbaren Funksenders der eingangs genannten Art zugrunde, der möglichst einfach aufgebaut ist und daher auch als kompakter Funkschlüssel für ein Kraftfahrzeug realisiert sein kann und bei dem unerwünschte Schwankungen in der abgestrahlten Sendeleistung vermieden werden.

Die Erfindung löst dieses Problem durch die Bereitstellung eines tragbaren Funksenders mit den Merkmalen des Anspruchs 1. Dieser Funksender beinhaltet als Spannungssignalgeneratorteil einen Oszillator, und die leistungsregelbare Verstärkerstufe enthält wenigstens einen mit seiner Basiselektrode an den Oszillator angeschlossenen Bipolartransistor, in dessen Kollektor-Emitter-Strompfad ein Stromstellelement der Leistungsregelschaltung eingeschleift ist, das vom Stellsignal des Operationsverstärkers gesteuert wird. Die Gleichrichterstufe weist eine Diode und gemeinsam mit der einen Diode an den zugehörigen Operationsverstärkereingang angekoppelt einen Widerstand und parallel zu diesem Widerstand einen Kondensator auf.

Mit dieser Anordnung wird ein einfach aufgebauter Funksender realisiert, dessen Sendeleistung geregelt werden kann, so daß unerwünschte Sendeleistungsschwankungen verhindert werden. Wenn die Leistungsvorgabespannung variabel einstellbar ist, kann bei Bedarf zudem die abgegebene Funksendeleistung entsprechend variiert werden. Durch seinen einfachen Aufbau eignet sich der Funksender insbesondere auch als Funkschlüssel für ein Automobil oder ein anderes Kraftfahrzeug.

Bei einem nach Anspruch 3 weitergebildeten Funksender wird die Leistungsvorgabespannung dem Operationsverstärker über eine Temperaturkompensationsdiode zugeführt, die eine eventuelle Temperaturdrift der in der Gleichrichterstufe vorgesehenen Diode kompensiert. Dazu ist die Kompensationsdiode zweckmäßigerweise so ausreichend nah an der Diode der Gleichrichterstufe positioniert, daß beide Dioden dieselben Temperatureinflüsse erfahren. Insbesondere können sich bei Wahl eines integrierten Schaltkreisaufbaus für den Funksender beide Dioden auf einer gemeinsamen Chipfläche befinden.

Bei einem nach Anspruch 4 weitergebildeten Funksender besteht die Verstärkerstufe aus einem Paar von Bipolartransistoren mit jeweils an einen von zwei Signalausgängen des Oszillators angeschlossener Basiselektrode, und das vom Operationsverstärker gesteuerte Stromstellelement besteht aus einem Transistor eines von zwei Transistoren gebildeten Stromspiegel-Schaltkreises, mit dem die Stromstärke im Kollektor-Emitter-Strompfad der beiden Verstärkertransistoren und damit deren Verstärkung und die von ihnen abgegebene Leistung variiert werden können. Die benötigten vier Transistoren lassen sich in Weiterbildung der Erfindung nach Anspruch 5 zusammen mit dem Oszillator problemlos in einem integrierten Schaltkreis realisieren.

Bei einem nach Anspruch 6 weitergebildeten Funksender mit magnetischer Funksendeantenne wird das Rückkopplungsspannungssignal über eine im Wirkbereich der Antenne liegende Rückkopplungsantenne gewonnen.

Bei einem nach Anspruch 7 weitergebildeten Funksender ist eine Leistungsvorgabespannungs-Einstelleinheit vorgesehen, durch die mehrere verschiedene Leistungsvorgabespannungswerte eingestellt werden können, so daß dementsprechend je nach Bedarf unterschiedliche Sendeleistungen des Funksenders ausgewählt werden können.

Bei einem nach Anspruch 8 weitergebildeten Funksender ist eine ASK- oder AM-Modulation realisierbar, indem eine entsprechende ASK- oder AM-Modulationseinheit vorgesehen ist, die ein zugehöriges Modulationssignal für die Leistungsvorgabespannung erzeugt.

Vorteilhafte Ausführungsbeispiele der Erfindung sind in den Zeichnungen dargestellt und werden nachfolgend beschrieben. Hierbei zeigen:
- Fig. 1: ein Schaltbild eines Funkschlüssels für ein Automobil mit Sendeleistungsregelung in voll integrierter Bauweise,
- Fig. 2: ein Schaltbild entsprechend Fig. 1 mit einer konkreten Realisierung eines leistungsregelnden Operationsverstärkers,
- Fig. 3: ein Schaltbild eines Funksenders entsprechend Fig. 1, jedoch mit zusätzlicher ASK-Modulationsfunktionalität,
- Fig. 4: ein Schaltbild eines Funksenders entsprechend Fig. 1, jedoch mit zusätzlicher linearer AM-Modulationsfunktionalität,
- Fig. 5: ein Schaltbild eines Funksenders entsprechend Fig. 1, jedoch mit mehrstufig verstellbarer Sendeleistung, und
- Fig. 6: ein Schaltbild eines Funksenders entsprechend Fig. 1, jedoch in nur teilweise integrierter Ausführung und mit Antennenrückkopplung.

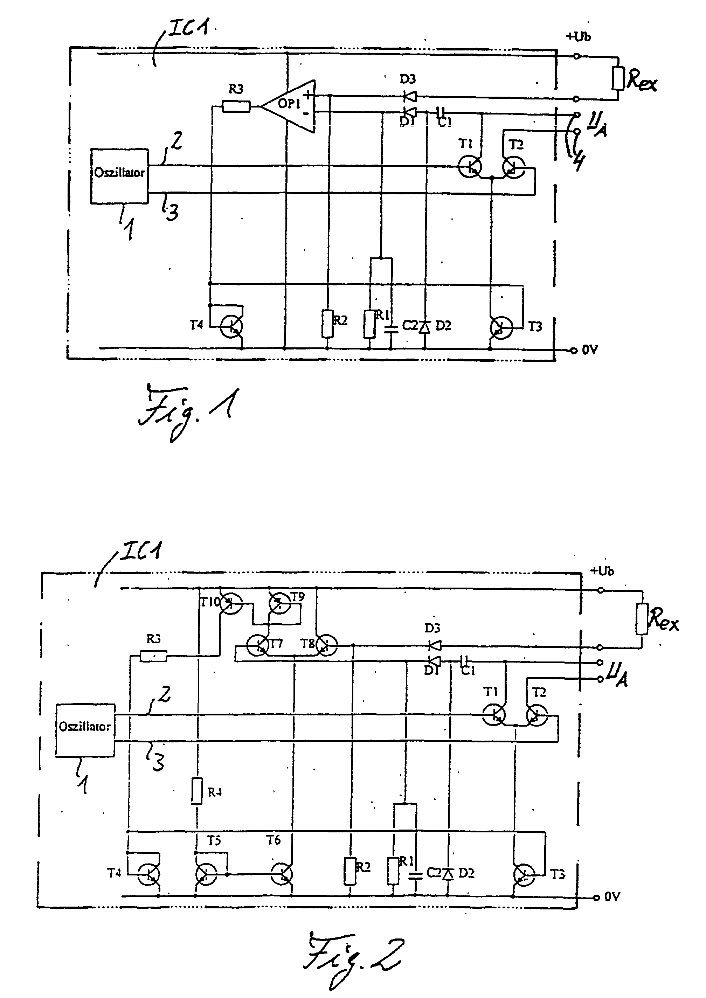

Fig. 1 zeigt als Schaltbild einen tragbaren Funksender, der einen Funkschlüssel für ein Automobil bildet, in seinen einzelnen Komponenten mit Ausnahme der zugehörigen Funksendeantenne. Der Funkschlüssel beinhaltet einen Oszillator 1 als Spannungssignalgeneratorteil mit zwei Ausgängen 2, 3, eine leistungsregelbare Verstärkerstufe in Form von zwei Bipolartransistoren T1, T2 mit verbundenen Emitteranschlüssen, eine Leistungsregelschaltung, die einen Operationsverstärker OP1 mit invertierendem und nichtinvertierendem Eingang und einen von zwei Bipolartransistoren T3, T4 gebildeten Stromspiegel-Schaltkreis umfaßt, sowie eine dem invertierenden Operationsverstärkereingang vorgeschaltete Gleichrichterstufe.

Die Basiselektroden der beiden Verstärkertransistoren T1, T2 sind mit jeweils einem der beiden Oszillatorausgänge 2, 3 verbunden. Ihr gemeinsamer Emitteranschluß ist über die Kollektor-Emitter-Strecke des einen Stromspiegel-Transistors T3 an Masse (0V) gekoppelt, während ihre beiden Kollektoranschlüsse die verstärkte Oszillatorausgangsspannung als Antennen-Hochfrequenzspannung U_{A} zur Speisung der nicht gezeigten Antenne bereitstellen, die hierzu an zugehörige Antennenanschlüsse 4 anschließbar ist.

Der im Emitterstrompfad der Verstärkertransistoren T1, T2 liegende Stromspiegel-Transistor T3 ist ebenso wie der andere Stromspiegel-Transistor T4 an seiner Basis von dem über einen Widerstand R3 geführten Operationsverstärker-Ausgangssignal beaufschlagt, das zudem zum Kollektor des letztgenannten Transistors T4 geführt ist, während dessen Emitter ebenso wie derjenige des erstgenannten Stromspiegel-Transistors T3 an Masse angekoppelt ist.

Das vom Kollektor gelieferte Hochfrequenz-Spannungssignal des einen Verstärkertransistors T1 bildet ein Rückkopplungs-Spannungssignal, das der Gleichrichterstufe über einen eingangsseitigen ersten Kondensator C1 zugeführt wird. An den ersten Kondensator C1 schließen sich eine erste, zum invertierenden Operationsverstärkereingang führende Diode D1 und eine zweite, nach Masse führende Diode D2 an. Der invertierende Operationsverstärkereingang ist zudem über eine Parallelschaltung aus einem Widerstand R1 und einem zweiten Kondensator C2 an Masse angekoppelt. Die beiden Dioden D1, D2, der zweite Kondensator C2 und der Widerstand R 1 bilden somit eine Gleichrichterstufe, die am invertierenden Operationsverstärkereingang eine zur Antennen-Hochfrequenzspannung U_{A} weitestgehend proportionale Gleichspannung bereitstellt. Diese wird vom Operationsverstärker OP1 mit einer Leistungsvorgabespannung, nachfolgend auch Referenzspannung bezeichnet, verglichen, die über einen Spannungsteiler aus einem externen Vorgabewiderstand Rₑₓ und einem internen Spannungsteilerwiderstand R2 mit zusätzlicher Temperaturkompensationsdiode D3 aus einer Versorgungs-Gleichspannung +Ub gewonnen wird. Zur Spannungsversorgung ist der Operationsverstärker OP1 über entsprechende Versorgungsanschlüsse zum einen an Masse und zum anderen an die positive Versorgungsspannung +Ub angeschlossen.

Bis auf den externen Vorgabewiderstand Rₑₓ sind alle erwähnten Schaltungskomponenten auf einem gestrichelt umrahmt symbolisierten, integrierten Schaltkreis IC1 realisiert, der mit geringem Platzbedarf im Gehäuse eines elektronischen Fahrzeugschlüssels untergebracht werden kann. Indem der Vorgabewiderstand Rₑₓ extern, d.h. außerhalb des integrierten Schaltkreises IC1 angeordnet ist, kann je nach Bedarf eine gewünschte Referenzspannung und damit ein gewünschter Sollwert für die Antennensendeleistung durch Anschließen eines Vorgabewiderstands Rₑₓ mit entsprechendem Widerstandswert vorgegeben werden, ohne daß hierzu ein modifizierter integrierter Schaltkreis erforderlich ist.

Im Anwendungsfall eines Fahrzeug-Funkschlüssels erlaubt dies z.B. die Anpassung der Sendeleistung an unterschiedliche Gegebenheiten in verschiedenen Ländern durch Anschließen eines jeweils geeigneten Leistungsvorgabewiderstands Rₑₓ, während im übrigen derselbe Schaltungsaufbau und insbesondere derselbe integrierte Schaltkreis IC1 für alle Funkschlüssel verwendbar ist. Durch die Möglichkeit, die Sendeleistung über den externen Vorgabewiderstand Rₑₓ in gewünschter Weise einstellen und mit der Leistungsregelschaltung auf dem gewünschten Sollwert halten zu können, entfällt zudem die Notwendigkeit, aus Funkschlüsseln mit aufgrund von Fertigungstoleranzen hohen Schwankungen in der Sendeleistung diejenigen mit zu hoher und zu niedriger Sendeleistung aussortieren zu müssen. Außerdem kann sichergestellt werden, daß alle für ein Fahrzeug gültigen Funkschlüssel weitestgehend dieselbe Sendeleistung und damit Reichweite aufweisen, so daß sich für den Nutzer keine unerwünschten Reichweitenschwankungen zwischen verschiedenen Schlüsseln ergeben.

Die Leistungsregelschaltung mit dem Operationsverstärker OP1 sorgt für die Einhaltung des gewünschten Sollwertes für die Antennen-Hochfrequenzspannung U_{A} und damit für die Antennensendeleistung. Sobald eine diesbezügliche Regelabweichung auftritt, weicht der Wert der von der Gleichrichterstufe aus der Antennen-Hochfrequenzspannung U_{A} gelieferten Rückkopplungs-Gleichspannung am invertierenden Operationsverstärkereingang von der am nicht-invertierenden Operationsverstärkereingang anliegenden Referenzspannung ab. Der Operationsverstärker OP1 reagiert darauf mit einem entgegenwirkenden Ausgangssignal, das je nach Richtung der Regelabweichung zu einem größeren oder kleineren Stromfluß durch den einen Stromspiegel-Transistor T4 führt, was eine entsprechende Stromänderung im anderen Stromspiegel-Transistor T3 zur Folge hat. Da die Steilheit der bipolaren Verstärkertransistoren T1, T2 einerseits deren Verstärkung bestimmt und andererseits näherungsweise proportional zum Kollektorstrom ist, führt die vom Stromspiegel bewirkte Stromstärkeänderung zu einer entsprechenden, der Regelabweichung entgegenwirkenden Verstärkungsänderung der Verstärkertransistoren T1, T2, wodurch die aufgetretene Regelabweichung der Antennen-Hochfrequenzspannung U_{A} und damit der Antennensendeleistung wieder ausgeregelt wird.

Die Temperaturkompensationsdiode D3 vor dem nicht-invertierenden Operationsverstärkereingang dient der Kompensation des Temperaturverhaltens der vor dem invertierenden Operationsverstärkereingang liegenden Diode D1. Denn mit steigender Temperatur wird die an der gleichrichtenden Diode D1 abfallende Spannung kleiner, so daß die am invertierenden Operationsverstärkereingang anliegende Rückkopplungs-Gleichspannung anwächst. Indem die Temperaturkompensationsdiode D3 vor dem nicht-invertierenden Operationsverstärkereingang dasselbe Temperaturverhalten zeigt, ändert sich temperaturabhängig im gleichen Maß auch die Referenzspannung, wodurch ein temperaturbedingtes Fehlverhalten der Leistungsregelschaltung vermieden wird. Es versteht sich, daß die Temperaturkompensationsdiode D3 zu diesem Zweck so angeordnet ist, daß sie auch tatsächlich demselben Temperatureinfluß unterliegt wie die gleichrichtende Diode D1. Dies wird z.B. dadurch gewährleistet, daß die Temperaturkompensationsdiode D3 in der Nähe der gleichrichtenden Diode D1 auf einer gemeinsamen Chipfläche des integrierten Schaltkreises IC1 angeordnet wird.

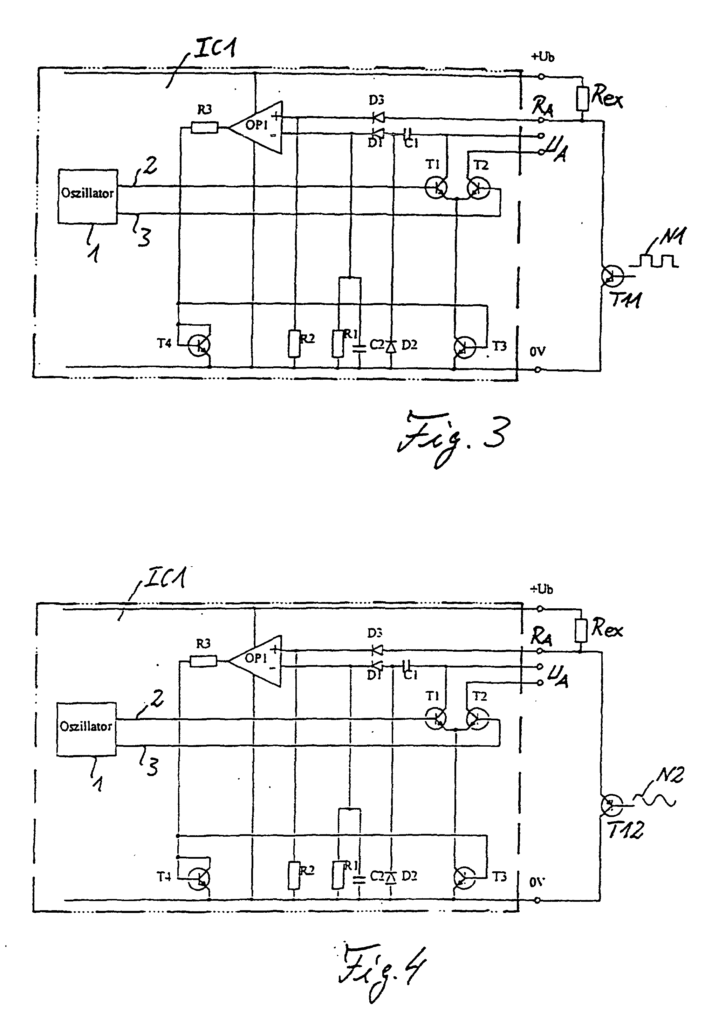

Fig. 2 zeigt die Funkschlüsselschaltung von Fig. 1 mit einer konkreten Realisierung des Operationsverstärkers aus sechs weiteren Transistoren T5 bis T10 und einem zusätzlichen Widerstand R4. Der Typ und die Verschaltung der sechs verwendeten Bipolartransistoren T5 bis T10 für den Operationsverstärker ist in dieser Figur unmittelbar dargestellt, und der Fachmann erkennt daraus ohne weiteres die übliche Funktion des in dieser Weise herkömmlich aufgebauten Operationsverstärkers, so daß hierauf nicht weiter eingegangen werden braucht. Im übrigen ist die Schaltung von Fig. 2 identisch mit derjenigen von Fig. 1, so daß insoweit auf die obigen Erläuterungen zu Fig. 1 verwiesen werden kann.

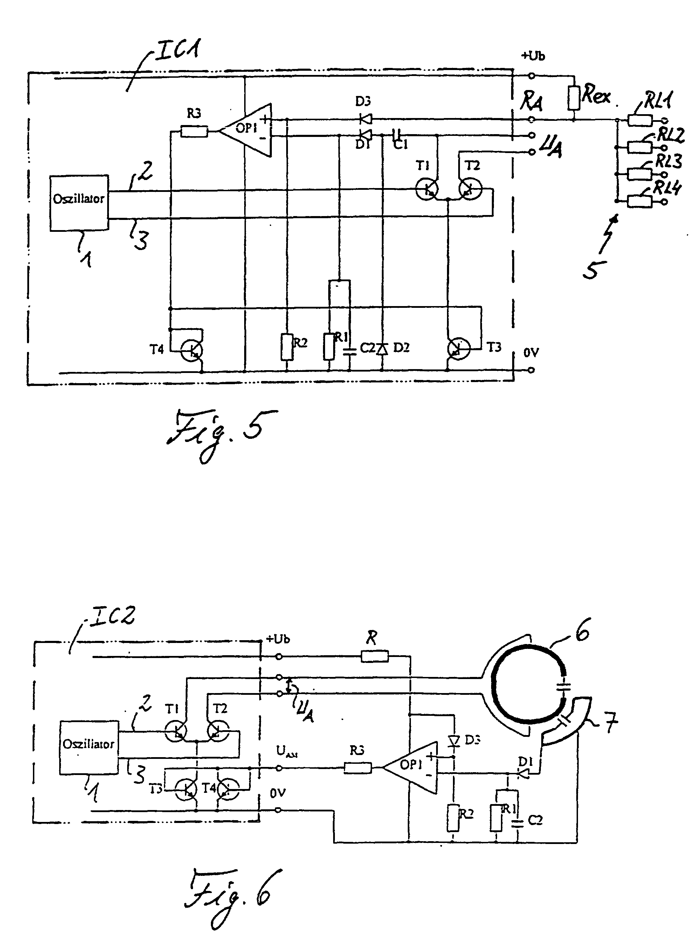

Fig. 3 zeigt ein Schaltbild eines gegenüber demjenigen der Fig. 1 und 2 dahingehend modifizierten Funksenders, daß er eine ASK (Amplitude Shift Keying)-Modulationseinheit, d.h. Amplitudenumtast-Modulationseinheit umfaßt, mit der eine ASK-Modulation bei voller Aufrechterhaltung der Leistungsregelung ermöglicht wird. Die in diesem Beispiel zusätzlich vorgesehene ASK-Modulationseinheit besteht aus einem weiteren, externen Bipolartransistor T11, dessen Basiselektrode von einem Niederfrequenz-Modulationssignal N1 beaufschlagbar ist und dessen Kollektor-Emitter-Strecke zwischen Masse und dem Referenzspannungsanschluß R_{A} des integrierten Schaltkreises IC1 eingeschleift ist, an den parallel der Leistungsvorgabewiderstand Rₑₓ angeschlossen ist, der an seinem anderen Anschluß mit der Versorgungs-Gleichspannung +Ub beaufschlagt ist. Im übrigen ist der Schaltungsaufbau des Funkschlüssels von Fig. 3 identisch mit demjenigen der Fig. 1 und 2, so daß auf deren obige Beschreibung verwiesen werden kann. Beim Funkschlüssel von Fig. 3 wird wiederum über den Vorgabewiderstand Rₑₓ der Referenz-Gleichspannungsanteil und damit über die Signalamplitude der Antennen-Hochfrequenzspannung U_{A} die Antennensendeleistung vorgegeben. Dieser Referenz-Gleichspannungsanteil wird durch den zusätzlichen, externen Modulationstransistor T11 mit der gewünschten ASK-Modulation moduliert, was wiederum zu einer entsprechenden Modulation der Verstärkung der beiden Verstärkertransistoren T1, T2 führt.

Fig. 4 zeigt das Schaltbild eines Funksenders, der wie derjenige von Fig. 3 zusätzlich zum Funksender der Fig. 1 und 2 mit einer Modulationseinheit versehen ist, die in diesem Fall jedoch zur Bewirkung einer linearen AM-Modulation, d.h. einer linearen Amplitudenmodulation, ausgelegt ist. Hierzu beinhaltet die Modulationseinheit von Fig. 4 statt des in Fig. 3 verwendeten Modulationstransistors T11 vom npn-Typ mit an Masse angeschlossenem Emitter und an den Referenzspannungsanschluß R_{A} angeschlossenem Kollektor einen modulierenden Bipolartransistor T12 vom pnp-Typ mit an Masse angeschlossenem Kollektor und an den Referenzspannungsanschluß R_{A} angeschlossenem Emitter. Die Basis des Modulationstransistors T12 ist mit einem gewünschten Niederfrequenz-Modulationssignal N2 beaufschlagbar. Im übrigen entsprechen Aufbau und Funktionsweise des Funksenders von Fig. 4 denjenigen der Fig. 1 bis 3, worauf verwiesen werden kann.

Der gemäß Fig. 4 aufgebaute Funksender ermöglicht eine lineare AM-Modulation beispielsweise zur Übertragung von Sprache und Musik mit geregelter Antennensendeleistung, wobei durch die Leistungsregelschaltung eine hohe Linearität erhalten wird. Die Leistungsregelschaltung sorgt dafür, daß die Antennen-Hochfrequenzspannung U_{A} am Ausgang der Verstärkertransistoren T1, T2 exakt proportional zur modulierten Niederfrequenz-Wechselspannung am Referenzspannungsanschluß R_{A} ist.

Fig. 5 zeigt den Schaltungsaufbau eines Funksenders mit mehrstufig veränderbarer Antennensendeleistung. Dazu ist zusätzlich zum Funksender-Schaltungsaufbau der Fig. 1 und 2 eine Leistungsvorgabespannungs-Einstelleinheit 5 vorgesehen, die mehrere, parallel angeordnete Widerstände RL1, RL2, RL3, RL4 und eine nicht gezeigte Prozessoreinheit umfaßt, mit der die parallelen Widerstände RL1 bis RL4 in beliebiger Kombination aktiviert werden können. Das Aktivieren bzw. Deaktivieren des jeweiligen Widerstands RL1 bis RL4 bedeutet hierbei das Schließen bzw. Unterbrechen der Verbindung seines prozessorseitigen, in Fig. 5 freien Anschlusses mit Masse, während die Widerstände RL1 bid RL4 mit ihrem anderen Anschluß an den Referenzspannungsanschluß R_{A} angeschlossen sind. Die jeweils aktiven Widerstände bilden daher mit dem zwischen dem Referenzspannungsanschluß R_{A} und der Versorgungsspannung +Ub liegenden Leistungsvorgabewiderstand Rₑₓ und dem internen Widerstand R2 eine Spannungsteileranordnung. Mit dieser sind im gezeigten Fall von vier prozessorseitig aktivierbaren Widerständen RL1 bis RL4 sechzehn unterschiedliche Referenzspannungen und damit Antennensendeleistungen einstellbar. Im Anwendungsfall eines Fahrzeug-Funkschlüssels bietet dies z.B. die Möglichkeit, den Abstand des den Funkschlüssel betätigenden Benutzers zum Fahrzeug abzuschätzen und/oder die Sendereichweite zum Öffnen einer Fahrzeugschließanlage durch den Funkschlüssel geringer zu halten als zum Schließen. Des weiteren ist damit auch sehr einfach eine Komfortschließung mit reduzierter Reichweite realisierbar.

Fig. 6 zeigt den Schaltungsaufbau eines Funksenders, bei dem das Rückkopplungsspannungssignal nicht wie bei den zuvor beschriebenen Funksendern vom Ausgangssignal eines der Verstärkertransistoren T1, T2, sondern vom abgestrahlten Antennensignal abgegriffen wird. Soweit der Funksender von Fig. 6 in seinem Schaltungsaufbau demjenigen der Fig. 1 und 2 entspricht, sind für die betreffenden Komponenten gleiche Bezugszeichen verwendet, und es wird dazu auf die obige Beschreibung zu den Fig. 1 und 2 verwiesen. Insbesondere wird die Antennen-Hochfrequenzspannung U_{A} wiederum über den Oszillator 1 und die beiden Verstärkertransistoren T1, T2 bereitgestellt und einer in diesem Fall explizit gezeigten, magnetischen Antenne 6 zugeführt. Auch die Leistungsregelschaltung mit dem Operationsverstärker OP1 und dem vom Operationsverstärker-Ausgangssignal über einen Widerstand R3 angesteuerten Stromspiegel T3, T4 entspricht derjenigen der Fig. 1 und 2, wobei jedoch in diesem Beispiel nur der Oszillator 1, die beiden Verstärkertransistoren T1, T2 und die beiden Stromspiegel-Transistoren T3, T4 in einem integrierten Schaltkreis IC2 integriert sind, während die übrigen Schaltungselemente extern angeordnet sind. In Anpassung an die externe Positionierung des Operationsverstärkers OP1 beinhaltet der integrierte Schaltkreis IC2 im Unterschied zum integrierten Schaltkreis IC1 der Fig. 1 bis 5 einen Stromspiegel-Steueranschluß Uₐₘ, während gleichzeitig der Referenzspannungsanschluß R_{A} entfällt.

Es versteht sich, daß diese Aufteilung der Schaltungskomponenten mit extern angeordnetem Operationsverstärker samt vorgeschalteter Gleichrichterstufe auch für die gemäß den Fig. 1 bis 5 aufgebauten Funksender möglich ist, wenn hierfür der integrierte Schaltkreisbaustein IC2 gemäß Fig. 6 zur Verfügung steht. Umgekehrt kann selbstverständlich der in den Fig. 1 bis 5 gezeigte, integrierte Schaltkreisbaustein IC1 zur Realisierung des gemäß Fig. 6 verschalteten Funksenders alternativ zum dortigen integrierten Schaltkreis IC2 verwendet werden, wobei dann der Operationsverstärker OP1 samt vorgeschalteter Gleichrichterstufe im integrierten Schaltkreis enthalten ist.

Die Gleichrichterstufe beinhaltet wiederum die vor dem invertierenden Operationsverstärkereingang liegende erste Diode D1 und die zwischen Masse und dem invertierenden Operationsverstärkereingang liegende Parallelschaltung aus dem Kondensator C2 und dem Widerstand R1. Zur Bereitstellung der Referenzspannung am nicht-invertierenden Operationsverstärkereingang ist wiederum der Spannungsteiler mit dem Leistungsvorgabewiderstand Rₑₓ, der Temperaturkompensationsdiode D3 und dem weiteren, im Schaltungsaufbau von Fig. 6 ebenfalls extern angeordneten Spannungsteilerwiderstand R2 zwischen Masse und positiver Versorgungsspannung +Ub vorgesehen. Die Temperaturkompensationsdiode D3, die hier wie die gleichrichtende Diode D1 außerhalb des integrierten Schaltkreises IC2 angeordnet ist, wird so plaziert, daß sie denselben Temperatureinflüssen unterliegt wie die gleichrichtende Diode D1, um ihre Temperaturkompensationsfunktion zu erfüllen.

Das zur Leistungsregelung der Gleichrichterstufe zugeführte Rückkopplungsspannungssignal wird beim Funksender von Fig. 6 von einer Rückkopplungsantenne 7 geliefert, die im magnetischen Wirkkreis der Sendeantenne 6 liegt und auf diese Weise in der Lage ist, deren Sendeleistung abzutasten. Die Rückkopplungsantenne 7 beinhaltet in integrierter Form die Funktion des eintrittsseitigen Kondensators Cl und der zweiten Diode D2 der Gleichrichterstufen in den Schaltungen der Fig. 1 bis 5.

Die obige Erläuterung bevorzugter Ausführungsbeispiele macht deutlich, daß der erfindungsgemäße, tragbare Funksender mit relativ wenigen Komponenten einfach und kompakt aufgebaut werden kann und daher insbesondere als Funkschlüssel für ein Kraftfahrzeug ausgelegt sein kann. Je nach Bedarf und Gegebenheiten können mehr oder weniger von den benötigten Schaltkreiskomponenten in einem integrierten Schaltkreisbaustein enthalten sein. Selbstverständlich ist auch eine vollständig diskrete Schaltungsrealisierung des Funksenders möglich.

## Patentansprüche

1. Tragbarer Funksender, insbesondere Funkschlüssel für ein Kraftfahrzeug, mit:
- einem Spannungssignalgeneratorteil mit einem Oszillator (1) zur Erzeugung eines Wechselspannungssignals,
- einer leistungsregelbaren Verstärkerstufe (T1, T2) zur Verstärkung des Wechselspannungssignals,
- einer Leistungsregelschaltung (OP1, T3, T4) für die Verstärkerstufe mit einem Operationsverstärker (OP1), dessen Ausgangssignal als Leistungsregelungs-Stellsignal dient und dessen einem Eingang (OP1+) eine Leistungsvorgabespannung zugeführt ist, während seinem anderen Eingang (OP1-) eine Gleichrichterstufe (D1, C2, R1) vorgeschaltet ist, der ein für das verstärkte Wechselspannungssignal indikatives Rückkopplungsspannungssignal zugeführt ist, und
- einer vom verstärkten Wechselspannungssignal (U_{A}) gespeisten Funksendeantenne (6),
**dadurch gekennzeichnet, dass**
- die leistungsregelbare Verstärkerstufe wenigstens einen mit seiner Basiselektrode an den Oszillator angeschlossenen Bipolartransistor (T1, T2) enthält, in dessen Kollektor-Emitter-Strompfad ein vom Operationsverstärker-Ausgangssignal gesteuertes Stromstellelement (T3) der Leistungsregelschaltung eingeschleift ist,
- die Gleichrichterstufe eine Diode (D1) beinhaltet und gemeinsam mit der einen Diode (D1) an den zugehörigen Operationsverstärkereingang angekoppelt einen Kondensator (C2) und parallel zu diesem Kondensator (C2) einen Widerstand (R1) beinhaltet.

2. Tragbarer Funksender nach Anspruch 1, **dadurch gekennzeichnet, dass**
die Gleichrichterstufe weiterhin eine weitere Diode (D2) aufweist, die mit ihrem einen Anschluss mit der Verbindung zwischen der leistungsregelbaren Verstärkerstufe (T1, T2) und der einen Diode (D1) verbunden ist und mit ihrem anderen Anschluss mit Masse verbunden ist, wobei bei einer dieser Dioden die Anode und bei der an deren dieser Dioden die Kathode mit der Verbindung verbunden ist.

3. Tragbarer Funksender nach Anspruch 1 oder 2, weiter **dadurch gekennzeichnet, dass**
die Leistungsvorgabespannung dem Operationsverstärker (OP1) über eine Temperaturkompensationsdiode (D3) zugeführt ist.

4. Tragbarer Funksender nach Anspruch 1, 2 oder 3, weiter **dadurch gekennzeichnet, dass**
die Verstärkerstufe aus einem Paar von Bipolartransistoren (T1, T2) mit jeweils an einen Oszillatorausgang angeschlossener Basiselektrode und mit verbundenen Emitterelektroden besteht und das Stromstellelement von einem im Emitterstrompfad der Verstärkertransistoren liegenden Transistor (T3) gebildet ist, der einen von zwei Transistoren (T3, T4) eines vom Operationsverstärker-Ausgangssignal angesteuerten Stromspiegels darstellt.

5. Tragbarer Funksender nach Anspruch 4, weiter **dadurch gekennzeichnet, dass**
wenigstens der Oszillator (1), die beiden Verstärkertransistoren (T1, T2) und die beiden Stromspiegeltransistoren (T3, T4) gemeinsam in einem integrierten Schaltkreis (IC1, IC2) enthalten sind.

6. Tragbarer Funksender nach einem der Ansprüche 1 bis 5, weiter **dadurch gekennzeichnet, dass**
die Funksendeantenne (6) eine magnetische Antenne (6) ist und zur Erzeugung des Rückkopplungssignals eine im magnetischen Wirkkreis der Funksendeantenne (6) positionierte Rückkopplungsantenne (7) vorgesehen ist.

7. Tragbarer Funksender nach einem der Ansprüche 1 bis 6, weiter **gekennzeichnet durch**
eine Leistungsvorgabespannungs-Einstelleinheit (5) zur mehrstufigen Einstellung verschiedener Antennesendeleistungs-Sollwerte.

8. Tragbarer Funksender nach einem der Ansprüche 1 bis 7, weiter **gekennzeichnet durch**
eine AM- oder ASK-Modulationseinheit (T12, T11) zur AM- oder ASK-Modulation der Leistungsvorgabespannung.

## Claims

1. Portable radio transmitter, in particular radio-controlled key for a motor vehicle, with:
- a voltage signal generator part with an oscillator (1) for the generation of an ac signal,
- a power-controllable amplifier stage (T1, T2) for the amplification of the ac signal,
- a power control circuit (OP1, T3, T4) for the amplifier stage with an operational amplifier (OP1), the output signal of which serves as a power control signal and one of the inputs of which (OP1+) is supplied with a power presetting voltage, while a rectifier stage (D1, C2, R1) supplied with a feedback voltage signal indicative of the amplified ac signal is connected in series with its other input (OP1-),
- with a radio transmission aerial (6) fed by the amplified ac signal (U_{A}), **characterised in that**
- the power-controllable amplifier stage incorporates at least one bipolar transistor (T1, T2), the base electrode of which is connected to the oscillator, and into the collector-emitter circuit of which a current control element (t3) of the power control circuit controlled by the output signal of the operational amplifier is looped,
- the rectifier stage incorporates a diode (D 1), a capacitor (C2) coupled, together with the one diode (D1), to the associated operational amplifier input, and a resistor (R1) connected in parallel with said capacitor (C2).

2. Portable radio transmitter according to claim 1, **characterised in that**
the rectifier stage further incorporates a further diode (D2), one terminal of which is connected to the connection between the power-controllable amplifier stage (T1, T2) and the one diode (D1), while the other terminal is connected to earth, whereby the anode of one of these diodes and the cathode of the other of these diodes is connected to the connection.

3. Portable radio transmitter according to claim 1 or 2, further **characterised in that** the power presetting voltage is fed to the operational amplifier (OP1) via a temperature compensation diode (D3).

4. Portable radio transmitter according to claim 1, 2 or 3, further **characterised in that**
the amplifier stage comprises a pair of bipolar transistors (T1, T2) with base electrodes connected to an oscillator output and with connected emitter electrodes, and **in that** the current control element is represented by a transistor (T3) installed in the emitter circuit of the amplifier transistors and forming one of two transistors (T3, T4) of a current mirror driven by the output signal of the operational amplifier.

5. Portable radio transmitter according to claim 4, further **characterised in that**
at least the oscillator (1), the two amplifier transistors (T1, T2) and the two current mirror transistors (T3, T4) are together contained in an integrated circuit (IC1, IC2).

6. Portable radio transmitter according to any of claims 1 to 5, further **characterised in that**
the radio transmission aerial (6) is a magnetic aerial (6), and **in that** a feedback aerial (7) for generating the feedback signal is positioned in the magnetic circuit of the radio transmission aerial (6).

7. Portable radio transmitter according to any of claims 1 to 6, further **characterised in that**
an adjusting unit (5) for the power presetting voltage is provided for the multistage adjustment of various nominal values for aerial transmission power.

8. Portable radio transmitter according to any of claims 1 to 7, further **characterised in that**
an AM or ASK modulating unit (T12, T11) is provided for the AM or ASK modulation of the power presetting voltage.

## Revendications

1. Emetteur portable, notamment clef à télécommande radiofréquence pour un véhicule à moteur, comprenant :
- un générateur de signaux de tension avec un oscillateur (1) pour la production d'un signal de tension alternative,
- un étage amplificateur à puissance réglable (T1, T2) pour l'amplification du signal de tension alternative,
- un circuit de régulation de puissance (OP1, T3, T4) pour l'étage amplificateur avec un amplificateur opérationnel (OP1) dont le signal de sortie sert de signal de réglage pour la régulation de la puissance et dont l'une des entrées (OP1+) reçoit une tension prévue de puissance tandis que l'autre entrée (OP1-) est branchée avant un étage redresseur (D1, C2, R1) qui est conduit à un signal de tension de contre-réaction indicatif pour le signal de tension alternative amplifié, et
- une antenne d'émission (6) alimentée par le signal de tension alternative amplifié (U_{A}),
**caractérisé en ce que**
- l'étage amplificateur à puissance réglable comprend au moins un transistor bipolaire (T1, T2) dont la base est reliée à l'oscillateur, un élément de réglage du courant (T3), commandé par le signal de sortie de l'amplificateur opérationnel, du circuit de régulation de puissance étant intégré dans son circuit collecteur-émetteur,
- l'étage redresseur comprend une diode (D1) et, conjointement avec cette une diode (D1) couplée à l'entrée de l'amplificateur opérationnel correspondante, un condensateur (C2) et une résistance (R1) en parallèlement à ce condensateur (C2).

2. Emetteur portable selon la revendication 1, **caractérisé en ce que**
l'étage redresseur présente en outre une autre diode (D2) qui est reliée, avec l'une de ses bornes, au contact entre l'étage amplificateur à puissance réglable (T1, T2) et l'une de ses diodes (D1) et, avec son autre borne, à la masse, moyennant quoi l'anode d'une de ces diodes est reliée à l'étage amplificateur et la cathode est reliée à la masse.

3. Emetteur portable selon la revendication 1 ou 2, **caractérisé en outre en ce que**
la tension prévue de puissance est conduite à l'amplificateur opérationnel (OP1) en parcourant une diode de compensation de température (D3).

4. Emetteur portable selon la revendication 1, 2 ou 3, **caractérisé en outre en ce que**
l'étage amplificateur comprend une paire de transistors bipolaires (T1, T2), avec respectivement une électrode de base connectée à une sortie d'oscillateur et avec des électrodes d'émetteur reliées entre elles, et **en ce que** l'élément de réglage du courant est formé par un transistor (T3), situé dans le circuit d'émetteur des transistors d'amplificateur, qui représente l'un des deux transistors (T3, T4) d'un miroir de courant commandé par le signal de sortie de l'amplificateur opérationnel.

5. Emetteur portable selon la revendication 4, **caractérisé en outre en ce que**
au moins l'oscillateur (1), les deux transistors d'amplificateur (T1, T2) et les deux transistors à miroir de courant (T3, T4) sont compris dans un circuit intégré (IC1, IC2) commun.

6. Emetteur portable selon l'une des revendications 1 à 5, **caractérisé en outre en ce que**
l'antenne d'émission (6) est une antenne magnétique (6) et **en ce qu'**une antenne de contre-réaction (7) positionnée dans le rayon d'action magnétique de l'antenne d'émission (6) est prévue pour la production du signal de contre-réaction.

7. Emetteur portable selon l'une des revendications 1 à 6, **caractérisé en outre par**
une unité de réglage de la tension prévue de puissance (5) pour le réglage étagé de différentes valeurs de consigne de puissance d'émission de l'antenne.

8. Emetteur portable selon l'une des revendications 1 à 7, **caractérisé en outre par**
une unité de modulation AM ou ASK (T12, T11) pour la modulation AM ou ASK de la tension prévue de puissance.
